# FASCICULE DE BREVET EUROPEEN

(11) **EP 2 924 454 B1**
(45) Date de publication et mention de la délivrance du brevet: **12.04.2017**
(21) Numéro de dépôt: 15158695.5
(22) Date de dépôt: 11.03.2015
(51) Int. Cl.: G01R 31/36

(54) **Procédé d'estimation et de recalage de l'état de charge d'une cellule de batterie**
Verfahren zur Abschätzung und Neueinstellung des Ladezustands einer Batteriezelle
Method for estimating and resetting of the state of charge of a battery cell

(30) Priorité: 17.03.2014 FR 1452181
(43) Date de publication de la demande: 30.09.2015
(73) Titulaire: COMMISSARIAT À L'ÉNERGIE ATOMIQUE ET AUX ÉNERGIES ALTERNATIVES, 75015 Paris (FR); DECATHLON, 59650 Villeneuve d'Ascq (FR)
(72) Inventeur: Vinit, Laurent, 73370 LE BOURGET DU LAC (FR); Karoui, Fathia, 73000 Chambery (FR); Despesse, Ghislain, 38340 VOREPPE (FR); Brulais, Sébastien, 38400 SAINT MARTIN D'HERES (FR); Gros, Jean-Philippe, 38120 LE FONTANIL CORNILLON (FR)
(74) Mandataire: Thibon, Laurent

(56) Documents cités:
- EP-A1- 1 562 048
- JP-A- 2000 261 901
- US-A1- 2013 090 872

## Description

### Domaine

La présente demande concerne le domaine des batteries électriques de façon générale, et vise plus particulièrement la détection du passage d'une cellule élémentaire d'une batterie par une valeur particulière prédéterminée de charge. Elle vise aussi l'estimation de l'état de charge d'une cellule élémentaire d'une batterie et le recalage ou réajustement de cette estimation.

### Exposé de l'art antérieur

Une batterie électrique est un groupement de plusieurs cellules élémentaires rechargeables (piles, accumulateurs, etc.) reliées en série et/ou en parallèle entre deux noeuds ou bornes de fourniture de tension.

Dans certains systèmes, on souhaite pouvoir connaître à tout instant l'état de charge, aussi appelé SOC (de l'anglais "State of Charge") de chaque cellule élémentaire de la batterie, c'est-à-dire le rapport entre la charge contenue dans la cellule et la capacité totale de la cellule à l'instant considéré. Pour cela, une jauge (ou indicateur) d'état de charge peut être associée à chaque cellule de la batterie. Les jauges des cellules élémentaires peuvent être gérées par un dispositif de gestion de la batterie, qui estime l'état de charge de chaque cellule à partir d'algorithmes prédéfinis et de mesures réalisées par des capteurs reliés aux cellules de la batterie.

Avec les solutions d'estimation d'état de charge connues, on note généralement une dégradation de l'estimation avec le temps et avec le vieillissement des cellules de la batterie. Pour pallier à ce phénomène, il est connu de mettre en oeuvre des phases dites de recalage ou réajustement d'une jauge d'état de charge, qui consistent à adapter les algorithmes d'estimation, par exemple en modifiant des paramètres de ces algorithmes, pour leur permettre de continuer à fournir une estimation relativement fiable. Généralement, les méthodes connues de recalage de jauge d'état de charge consistent à charger ou décharger complètement la cellule, puis, lorsqu'une fin de charge ou une fin de décharge est détectée, à adapter les algorithmes d'estimation de façon à repositionner la jauge d'état de charge à 100% ou 0%. Un inconvénient de ces solutions est qu'elles nécessitent la mise en oeuvre d'une charge ou d'une décharge complète de la cellule, ce qui est relativement contraignant et peut poser problème dans certaines applications.

La demande de brevet EP1562048 décrit un procédé de mesure de la capacité d'une batterie.

### Résumé

Ainsi, un mode de réalisation prévoit un procédé de détection d'une valeur particulière prédéterminée de la charge contenue dans une première cellule élémentaire d'une batterie, comprenant les étapes suivantes : mesurer la tension aux bornes de la cellule à plusieurs instants d'une phase de charge ou de décharge de la cellule entre des premier et second niveaux d'état de charge ; et détecter une valeur particulière prédéterminée de cette tension, correspondant à la valeur particulière de charge, les valeurs particulières de charge et de tension correspondant aux coordonnées d'un point de croisement d'au moins deux courbes représentatives de l'évolution de la tension en fonction de la charge contenue dans la cellule, à des états de vieillissement distincts de la cellule.

Selon un mode de réalisation, la tension est la tension aux bornes de la cellule sous un courant de référence.

Selon un mode de réalisation, les valeurs particulières de charge et de tension correspondent aux coordonnées d'un point de croisement d'au moins trois courbes représentatives de l'évolution de la tension en fonction de la charge contenue dans la cellule, à des états de vieillissement distincts de la cellule.

Selon un mode de réalisation, la valeur particulière de charge est comprise entre 20% et 60% de la capacité nominale de pleine charge de la cellule.

Selon un mode de réalisation, la cellule est une cellule de type lithium-ion, et la valeur particulière de charge est comprise entre 38% et 42% de la capacité nominale de pleine charge de la cellule.

Selon un mode de réalisation, la cellule présente une capacité nominale de 2,2 Ah et une tension nominale de pleine charge de 4,2 V, et la valeur particulière de tension est comprise dans la plage allant de 3,5 à 3,6 V.

Selon un mode de réalisation, le procédé comporte en outre une phase préalable de caractérisation comportant l'acquisition, pour une deuxième cellule élémentaire de même type que la première cellule, d'au moins deux courbes caractéristiques représentatives de l'évolution de la tension aux bornes de la deuxième cellule en fonction de la charge contenue dans la deuxième cellule, à au moins deux états de vieillissement distincts de la deuxième cellule.

Selon un mode de réalisation, la phase préalable de caractérisation comprend en outre une étape de détermination d'un point de croisement des deux courbes caractéristiques dans la plage de charge allant de 20% à 60% de la capacité nominale de la cellule.

Un autre mode de réalisation prévoit un procédé d'évaluation de l'état de charge d'une cellule élémentaire d'une batterie, comprenant au moins une phase d'estimation de l'état de charge de la cellule par un algorithme d'estimation d'état de charge, et au moins une phase de recalage de l'algorithme d'estimation, la phase de recalage comprenant les étapes suivantes : détecter une valeur particulière prédéfinie de la charge contenue dans la cellule par un procédé du type susmentionné ; et recaler l'algorithme d'estimation d'état de charge en tenant compte de l'écart entre la valeur particulière de charge et une valeur de charge estimée par l'algorithme d'estimation à un instant de détection de la valeur particulière de charge.

Un autre mode de réalisation prévoit un système comportant : une batterie comportant plusieurs cellules élémentaires et un dispositif de gestion de la batterie, dans lequel le dispositif de gestion est adapté à détecter le passage d'une cellule élémentaire par une valeur particulière de charge prédéterminée par un procédé du type susmentionné.

Selon un mode de réalisation, la batterie est une batterie à architecture reconfigurable dynamiquement, et le dispositif de gestion est adapté à déconnecter et reconnecter dynamiquement des cellules de la batterie de façon que la batterie fournisse à ses bornes une tension alternative.

Selon un mode de réalisation, le courant de référence est nul, et les étapes de mesure de la tension aux bornes de la première cellule sont mises en oeuvre pendant des périodes de déconnexion de la première cellule par le dispositif de gestion en vue de la génération d'une tension alternative aux bornes de la batterie.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un diagramme illustrant l'évolution avec le vieillissement du comportement d'une cellule élémentaire de batterie ; et
la figure 2 illustre, sous forme de blocs, un exemple d'un mode de réalisation d'un procédé de recalage d'une jauge d'état de charge d'une cellule élémentaire de batterie.

### Description détaillée

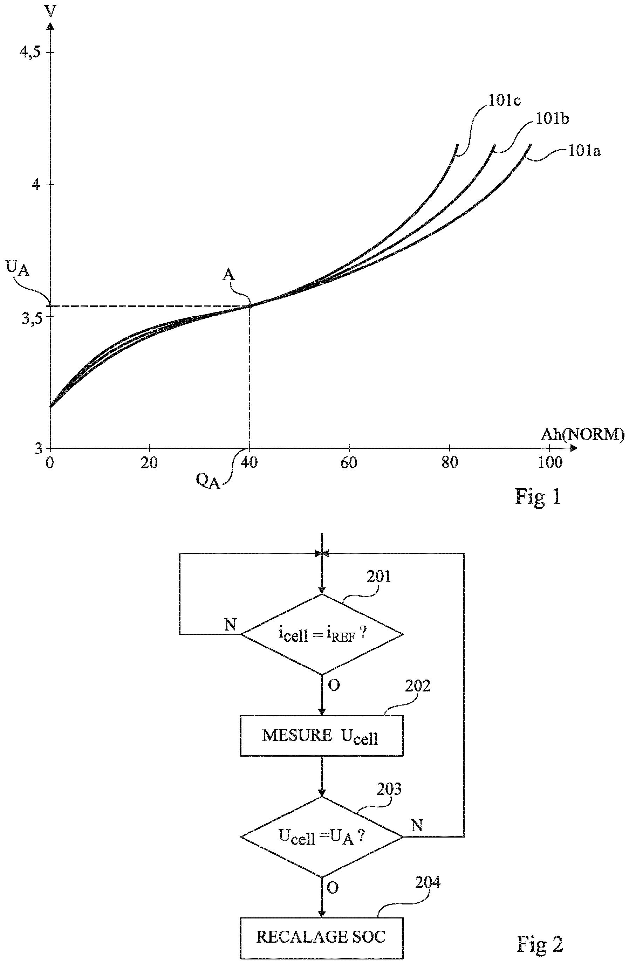

La figure 1 est un diagramme comportant trois courbes 101a, 101b et 101c représentant, pour trois états de vieillissement ou états de santé distincts d'une cellule de batterie, l'évolution de la tension U_{cell} en volts (V) aux bornes de la cellule sous un courant de référence i_{ref} (c'est-à-dire la tension aux bornes de la cellule lorsque la cellule est traversée par le courant i_{ref}), en fonction de la charge contenue dans la cellule. Les courbes de la figure 1 ont été tracées pour une cellule lithium-ion de type NMC (nickel cobalt manganèse)/graphite, présentant une capacité nominale (c'est-à-dire affichée par le fabricant) de 2,2 Ah, et une tension nominale de pleine charge de 4,2 V. La courbe 101a représente le comportement de la cellule à l'état neuf, la courbe 101b correspond à la même cellule après environ 600 cycles de charge/décharge représentatifs d'une utilisation typique de la cellule, et la courbe 101c correspond à la même cellule après environ 1200 cycles de charge/décharge représentatifs d'une utilisation typique de la cellule. Dans cet exemple, les mesures de tension ont été effectuées sous un courant de référence i_{ref} nul. De plus, sur la figure 1, la charge de la cellule, en abscisse, a été représentée en ampère-heure restants normalisés (Ah NORM), c'est-à-dire en pourcentage de la capacité nominale de la cellule. Il s'agit donc bien d'une grandeur représentative de la charge physique effectivement contenue dans la cellule (ou nombre d'Ah restants), et non pas de l'état de charge (SOC) de la cellule, qui, lui, est un pourcentage de la capacité totale réelle de la cellule qui peut varier avec le vieillissement de la cellule.

Les essais menés par les inventeurs ont montré que les courbes caractéristiques de la tension aux bornes de la cellule, sous un courant de référence constant, en fonction de la charge de la cellule, aux différents états de vieillissement de la cellule, sont toutes monotones (c'est-à-dire continument croissantes ou décroissantes) dans la plage d'utilisation de la cellule, et se croisent toutes en un même point caractéristique de la cellule, désigné ici par la référence A. Dans l'exemple particulier de la figure 1, le point A correspond à une tension U_{A} de 3,55 V et une charge Q_{A} de 40% de la capacité nominale de la cellule (soit 0,88 Ah dans cet exemple).

Les essais réalisés par les inventeurs ont en outre montré qu'un comportement similaire est observable lorsque les mesures de tension sont effectuées sous un courant de référence i_{ref} non nul, par exemple un courant négatif - c'est-à-dire un courant de décharge de la cellule - ou un courant positif - c'est-à-dire un courant de charge de la cellule. Dans ce cas, les coordonnées U_{A} et Q_{A} du point A peuvent changer par rapport à l'exemple de la figure 1, mais le même phénomène que dans l'exemple de la figure 1 se produit, c'est-à-dire que toutes les courbes caractéristiques tension/charge à des états de vieillissement distincts de la cellule se croisent en un même point A.

Les inventeurs ont en outre constaté que ce même phénomène est observable pour d'autres types de cellules que les cellules lithium-ion de l'exemple de la figure 1, par exemple des cellules lithium-ion présentant une capacité nominale différente de 2,2 Ah et/ou une tension nominale de pleine charge différente de 4,2 V, ou des cellules présentant une chimie différente, à condition que ces cellules présentent des caractéristiques tension/charge monotones (sans plateau), par exemple des cellules lithium-ion de type LMO (LiMn₂O₄)/graphite. La position du point A dépend alors des caractéristiques de la cellule et du courant de référence i_{ref} considéré, et se trouve typiquement dans la plage de charge allant de 20% à 60% de la capacité nominale de la cellule.

Pour un type de cellule donné, une phase de caractérisation peut être mise en oeuvre, permettant de déterminer la position du point A pour un courant de référence i_{ref} que l'on choisit, par exemple i_{ref} = 0 A. Un exemple non limitatif de procédé de caractérisation va maintenant être décrit.

Dans un premier temps, une cellule du type à caractériser, présentant un premier état de vieillissement, peut être complètement déchargée. Cette cellule peut ensuite être rechargée complètement en mesurant périodiquement pendant la charge la tension de la cellule sous le courant i_{ref}. La charge physique réelle contenue dans la cellule peut être mesurée tout au long de la phase de charge, par exemple à l'aide d'un compteur coulométrique ou d'un intégrateur de courant. On peut ainsi faire correspondre à chaque valeur de tension mesurée une valeur mesurée de charge contenue dans la cellule, de façon à obtenir une courbe caractéristique tension/charge du type représenté en figure 1. On notera que si le courant de charge est différent de i_{ref} (notamment dans le cas i_{ref}=0), on peut périodiquement forcer le courant traversant la cellule à la valeur i_{ref} pendant une courte durée, par exemple inférieure à 1 ms et de préférence inférieure à 10 µs, le temps d'effectuer une mesure de la tension aux bornes de la cellule.

Alternativement, la courbe caractéristique tension/charge peut être acquise pendant une phase de décharge complète de la cellule, plutôt que pendant une phase de charge.

La cellule peut ensuite être "vieillie" en étant soumise à des cycles de charge/décharge représentatifs d'une utilisation typique de la cellule.

Les étapes susmentionnées peuvent être répétées au moins une fois pour obtenir au moins une deuxième courbe caractéristique tension/charge du type représenté en figure 1, à au moins un deuxième état de vieillissement de la cellule.

Lorsqu'au moins deux courbes caractéristiques correspondant à des états de vieillissement distincts de la cellule ont été enregistrées, le point A peut être déterminé à partir de ces courbes, par exemple en recherchant le point de croisement entre deux courbes caractéristiques dans la plage de charge allant de 20% à 60% de la capacité nominale de la cellule.

Les mesures de tension en fonction de la charge effectuées lors de la phase de caractérisation peuvent optionnellement être lissées avant la détermination du point A. A titre d'exemple numérique non limitatif, des points des courbes caractéristiques tension/charge peuvent être acquis à une fréquence de 100 kHz (un point toutes les 10 µs), puis moyennés sur une fenêtre glissante de 2000 points (20 ms).

Une fois les coordonnées du point A connues pour un type de cellule et un courant de référence i_{ref}, elles peuvent être mémorisées par un dispositif de gestion d'une batterie comportant des cellules élémentaires de ce type.

La détection, par le dispositif de gestion, du passage d'une cellule de la batterie au point A lorsque la batterie est en cours d'utilisation, permet avantageusement au dispositif de gestion de connaître de façon fiable la charge disponible dans cette cellule, indépendamment d'éventuelles dérives des jauges de la batterie liées au vieillissement des cellules ou à d'autres phénomènes.

Le dispositif de gestion de la batterie est par exemple adapté à mettre en oeuvre, pour chaque cellule de la batterie, un procédé de détection d'un passage au point A comportant les étapes suivantes :
mesurer la tension aux bornes de la cellule sous le courant de référence i_{ref} à plusieurs instants d'une phase de charge ou de décharge de la cellule entre des premier et second niveaux d'état de charge de la cellule, par exemple entre 20% et 80% du SOC de la cellule ; et
détecter une valeur particulière prédéfinie U_{A} de cette tension, mémorisée dans le dispositif de gestion, cette tension correspondant à la coordonnée en tension du point A prédéterminée lors de la phase de caractérisation.

La phase de charge ou de décharge du procédé de détection du point A peut correspondre à une charge ou une décharge de la cellule par utilisation normale de la batterie par un système comportant la batterie, par exemple un véhicule à assistance électrique. Si le courant de charge ou de décharge normal de la cellule est différent du courant de référence i_{ref}, on peut périodiquement forcer le courant traversant la cellule à la valeur i_{ref} pendant une durée de préférence suffisamment courte pour ne pas gêner le fonctionnement, par exemple pendant une durée inférieure à 1 ms et de préférence inférieure à 10 µs, le temps d'effectuer une mesure de la tension aux bornes de la cellule. Cette durée est de préférence choisie, le cas échéant, identique ou similaire, par exemple égale à 20% près, à la durée pendant laquelle le courant est périodiquement forcé à la valeur i_{ref} pendant la phase de caractérisation pour acquérir des courbes caractéristiques de la cellule.

A titre de variante, le procédé de détection du point A peut comprendre une phase dédiée de charge ou de décharge de la cellule, qui peut être mise en oeuvre par le dispositif de gestion de la batterie spécifiquement pour provoquer un passage de la cellule par le point A et permettre ainsi la détection du passage au point A.

A titre d'exemple non limitatif, le procédé susmentionné de détection du passage au point A d'une cellule d'une batterie peut être utilisé en vue de recaler ou réajuster une jauge d'état de charge de la cellule. Le dispositif de gestion de la batterie peut par exemple mettre en oeuvre un procédé d'évaluation de l'état de charge d'une cellule de la batterie, ce procédé comportant des phases d'estimation de l'état de charge de la cellule, et, entre des phases d'estimation, des phases de recalage du procédé d'estimation permettant de compenser d'éventuelles dérives, par exemple des dérives liées au vieillissement de la cellule ou des dérives des mesures effectuées par des capteurs du dispositif de gestion, ces phases de recalage pouvant comprendre des phases de détection du passage au point A de la cellule.

A titre d'exemple, une jauge d'état de charge de la cellule peut être recalée suite à une phase de détection d'un passage au point A de la cellule, pour compenser un éventuel écart entre une valeur de charge estimée de la cellule et la valeur de charge réelle connue au point A, à l'instant de détection du point A.

Un avantage est que le recalage d'une jauge d'état de charge de la cellule par détection d'un passage au point A de la cellule ne nécessite pas une décharge complète ou une charge complète de la cellule. Ceci permet de rendre les phases de recalage nettement moins contraignantes qu'avec les solutions connues. On peut notamment prévoir des recalages plus fréquents que dans les systèmes existants. Ceci peut par exemple permettre d'utiliser des algorithmes d'estimation d'état de charge plus simples que dans les systèmes existants, puisqu'une éventuelle diminution de la fiabilité des algorithmes d'estimation peut être compensée par des recalages plus fréquents.

Les modes de réalisation décrits dans la présente demande de procédé de détection du passage au point A d'une cellule, ou de recalage d'une jauge d'état de charge d'une cellule, bien que ne se limitant pas à ce cas particulier, présentent un intérêt tout particulier pour une utilisation dans une batterie à architecture électrique reconfigurable dynamiquement. Par batterie à architecture électrique reconfigurable dynamiquement, on entend ici une batterie dans laquelle le schéma électrique d'interconnexion des cellules élémentaires de la batterie entre les bornes de fourniture de tension de la batterie peut être modifié dynamiquement pendant le fonctionnement de la batterie, de façon que la batterie fournisse à ses bornes une tension alternative, par exemple destinée à l'alimentation d'un moteur électrique ou de toute autre charge susceptible d'être alimentée par une tension alternative. Des exemples de réalisation de batteries à architecture électrique reconfigurable dynamiquement sont par exemple décrits dans les demandes de brevet FR2972304, FR2972305, FR2972306 et FR2972308 de la demanderesse.

Une batterie à architecture électrique reconfigurable dynamiquement comprend typiquement un dispositif de gestion capable de déconnecter et reconnecter dynamiquement des cellules de la batterie, éventuellement en modifiant leur position et/ou leur mode de connexion (série ou parallèle) par rapport aux autres cellules de la batterie, à une fréquence relativement élevée, pendant des phases d'utilisation de la batterie.

A chaque déconnexion d'une cellule, le courant traversant cette cellule s'annule pendant la période de déconnexion, par exemple comprise dans la plage allant de 1 µs à 1 ms. Avantageusement, le dispositif de gestion de la batterie peut exploiter ces fréquentes déconnexions pour mettre en oeuvre un procédé du type susmentionné de détection du point A de la cellule pour un courant de référence i_{ref} nul. Pour cela, le dispositif de gestion peut mesurer la tension de la cellule pendant des périodes de déconnexion de la cellule faisant partie du fonctionnement normal du système, jusqu'à détecter un passage de la cellule par la tension U_{A} du point A. Un avantage est que la détection du point A ne nécessite alors aucune perturbation du fonctionnement normal de la batterie.

La figure 2 illustre, sous forme de blocs, un exemple d'un mode de réalisation d'un procédé de recalage d'une jauge d'état de charge d'une cellule élémentaire d'une batterie, qui peut être mis en oeuvre pendant une phase de charge ou de décharge de la cellule.

Dans l'exemple de la figure 2, le procédé de recalage comprend une étape 201 (i_{cell}=i_{ref?}) au cours de laquelle le dispositif de gestion attend que le courant i_{cell} traversant la cellule passe par la valeur i_{ref}. Dans le cas d'une batterie à architecture reconfigurable dynamiquement, on peut choisir i_{ref}=0, auquel cas, lors de l'étape 201, si la batterie est en phase de décharge, le dispositif de gestion peut attendre la prochaine déconnexion de la cellule programmée en vue de la fourniture d'une tension alternative aux bornes de la batterie. Le cas échéant, le dispositif de gestion peut forcer à la valeur i_{ref} le courant traversant la cellule, spécifiquement pour la mise en oeuvre du procédé de recalage, pendant une durée suffisamment courte pour ne pas perturber de façon significative le fonctionnement normal de la batterie, par exemple pendant une durée inférieure à 1 ms et de préférence inférieure à 10 µs.

Lorsque le courant i_{cell} est à la valeur i_{ref}, le dispositif de gestion mesure la tension U_{cell} aux bornes de la cellule lors d'une étape 202 (MESURE U_{cell}).

Lors d'une étape 203 (U_{cell}=U_{A}?), le dispositif de gestion surveille le passage de la tension U_{cell} mesurée à l'étape 202 par la valeur de tension U_{A} du point caractéristique A de la cellule.

Si, lors de l'étape 203, le dispositif de gestion détecte le passage de la valeur de la tension U_{cell} mesurée sous le courant i_{ref} par la valeur U_{A}, il met en oeuvre une étape 204 (RECALAGE SOC) de recalage de la jauge d'état de charge de la cellule, en tenant compte de l'écart entre une valeur de charge estimée de la cellule et la valeur de charge réelle connue au point A, à l'instant de détection du point A. A la fin de l'étape 204, le procédé de recalage se termine.

Si, lors de l'étape 203, le dispositif de gestion ne détecte pas un passage de la valeur de la tension U_{cell} mesurée sous le courant i_{ref} par la valeur U_{A}, il met à nouveau en oeuvre les étapes 201, 202 et 203.

Des modes de réalisation particuliers ont été décrits. Diverses variantes et modifications apparaîtront à l'homme de l'art.

En particulier, le dispositif de gestion de la batterie peut optionnellement mémoriser, en plus des coordonnées du point A, l'intégralité d'une ou plusieurs des courbes caractéristiques tension/charge des cellules à un courant de référence i_{ref}. Dans ce cas, pour évaluer l'état de charge d'une cellule de la batterie, le dispositif de gestion peut effectuer une mesure de la tension aux bornes de la cellule sous le courant i_{ref}, et estimer l'état de charge de la cellule à partir de cette mesure et des courbes caractéristiques mémorisées. La courbe particulière utilisée pour effectuer une estimation d'état de charge d'une cellule peut être sélectionnée en tenant compte d'un indicateur d'état de vieillissement de la cellule.

Par ailleurs, les modes de réalisation décrits ne se limitent pas à l'utilisation du procédé de détection du point A pour recaler une jauge d'état de charge d'une cellule de batterie. La méthode proposée pourra être utilisée dans toute application pouvant tirer profit de la connaissance, à un instant donné, de la charge réelle contenue dans une cellule d'une batterie.

En outre, lors de la phase de caractérisation des cellules, le point A peut optionnellement être déterminé pour plusieurs courants de référence distincts. Dans ce cas, lorsque le dispositif de gestion met en oeuvre une phase de détection d'un passage d'une cellule de la batterie par un point A en vue de connaître, à un instant donné, la charge réelle contenue dans cette cellule, il peut choisir le courant de référence le mieux adapté à l'utilisation qui est faite de la batterie pendant la phase de détection.

## Revendications

1. Procédé de détection d'une valeur particulière prédéterminée (Q_{A}) de la charge contenue dans une première cellule élémentaire d'une batterie, comprenant les étapes suivantes :
mesurer la tension (U_{cell}) aux bornes de la cellule à plusieurs instants d'une phase de charge ou de décharge de la cellule entre des premier et second niveaux d'état de charge ; et
détecter une valeur particulière prédéterminée (U_{A}) de cette tension, correspondant à ladite valeur particulière de charge (Q_{A}), **caractérisé par** lesdites valeurs particulières de charge (Q_{A}) et de tension (U_{A}) correspondant aux coordonnées d'un point (A) de croisement d'au moins deux courbes (101a, 101b, 101c) représentatives de l'évolution de ladite tension (U_{cell}) en fonction de la charge contenue dans la cellule, à des états de vieillissement distincts de la cellule.

2. Procédé selon la revendication 1, dans lequel ladite tension (U_{cell}) est la tension aux bornes de la cellule sous un courant de référence (i_{ref}).

3. Procédé selon la revendication 1 ou 2, dans lequel lesdites valeurs particulières de charge (Q_{A}) et de tension (U_{A}) correspondent aux coordonnées d'un point (A) de croisement d'au moins trois courbes (101a, 101b, 101c) représentatives de l'évolution de ladite tension (U_{cell}) en fonction de la charge contenue dans la cellule, à des états de vieillissement distincts de la cellule.

4. Procédé selon l'une quelconque des revendications 1 à 3, dans lequel ladite valeur particulière de charge (Q_{A}) est comprise entre 20% et 60% de la capacité nominale de pleine charge de la cellule.

5. Procédé selon l'une quelconque des revendications 1 à 4, dans lequel ladite cellule est une cellule de type lithium-ion, et dans lequel ladite valeur particulière de charge (Q_{A}) est comprise entre 38% et 42% de la capacité nominale de pleine charge de la cellule.

6. Procédé selon la revendication 5, dans lequel ladite cellule présente une capacité nominale de 2,2 Ah et une tension nominale de pleine charge de 4,2 V, et dans lequel ladite valeur particulière de tension (U_{A}) est comprise dans la plage allant de 3,5 à 3,6 V.

7. Procédé selon l'une quelconque des revendications 1 à 6, comportant en outre une phase préalable de caractérisation comportant l'acquisition, pour une deuxième cellule élémentaire de même type que la première cellule, d'au moins deux courbes caractéristiques (101a, 101b, 101c) représentatives de l'évolution de la tension (U_{cell}) aux bornes de la deuxième cellule en fonction de la charge contenue dans la deuxième cellule, à au moins deux états de vieillissement distincts de la deuxième cellule.

8. Procédé selon la revendication 7, dans lequel la phase préalable de caractérisation comprend en outre une étape de détermination d'un point (A) de croisement desdites au moins deux courbes caractéristiques dans la plage de charge allant de 20% à 60% de la capacité nominale de la cellule.

9. Procédé d'évaluation de l'état de charge d'une cellule élémentaire d'une batterie, comprenant au moins une phase d'estimation de l'état de charge de la cellule par un algorithme d'estimation d'état de charge, et au moins une phase de recalage de l'algorithme d'estimation, ladite phase de recalage comprenant les étapes suivantes :
détecter une valeur particulière prédéfinie (Q_{A}) de la charge contenue dans la cellule par un procédé selon l'une quelconque des revendications 1 à 8 ; et
recaler l'algorithme d'estimation d'état de charge en tenant compte de l'écart entre ladite valeur particulière de charge (Q_{A}) et une valeur de charge estimée par l'algorithme d'estimation à un instant de détection de ladite valeur particulière de charge.

10. Système comportant :
une batterie comportant plusieurs cellules élémentaires ; et
un dispositif de gestion de la batterie, **caractérisé en ce que** le dispositif de gestion est adapté à détecter le passage d'une cellule élémentaire par une valeur particulière de charge prédéterminée (Q_{A}) par un procédé selon l'une quelconque des revendications 1 à 9.

11. Système selon la revendication 10, dans lequel la batterie est une batterie à architecture reconfigurable dynamiquement, et dans lequel le dispositif de gestion est adapté à déconnecter et reconnecter dynamiquement des cellules de la batterie de façon que la batterie fournisse à ses bornes une tension alternative.

12. Système selon la revendication 11 dans son rattachement à la revendication 2, dans lequel ledit courant de référence (i_{ref}) est nul, et dans lequel lesdites étapes de mesure de la tension (U_{cell}) aux bornes de la première cellule sont mises en oeuvre pendant des périodes de déconnexion de la première cellule par le dispositif de gestion en vue de la génération d'une tension alternative aux bornes de la batterie.

## Patentansprüche

1. Verfahren zum Detektieren eines vorbestimmten spezifischen Wertes der Ladung (Q_{A}), die in einer ersten Elementarzelle einer Batterie enthalten ist, welches folgende Schritte aufweist:
Messen der Spannung (U_{cell}) an der Zelle zu einer Vielzahl von Zeitpunkten in einer Phase der Zellenladung oder -entladung zwischen ersten und zweiten Ladungszustandspegeln; und
Detektieren eines vorbestimmten spezifischen Wertes dieser Spannung(U_{A}), entsprechend dem spezifischen Wert der Ladung (Q_{A}),
**dadurch gekennzeichnet, dass** der spezifischen Wert der Ladung (Q_{A}) und der spezifische Wert der Spannung (U_{A}) den Koordinaten eines Kreuzungspunktes (A) von mindestens zwei Kurven (101 a, 101b, 101c) entsprechen, welche die Veränderung der Spannung (U_{cell}) entsprechend der in der Zelle enthaltenen Ladung für unterschiedliche Gesundheitszustände der Zelle darstellen.

2. Verfahren nach Anspruch 1, wobei die Spannung (U_{cell}) die Spannung an der Zelle bei einem Referenzstrom (I_{ref}) ist.

3. Verfahren nach Anspruch 1 oder 2, wobei die Werte der spezifischen Ladung (Q_{A}) und der spezifischen Spannung (U_{A}) den Koordinaten eines Kreuzungspunktes (A) von mindestens drei Kurven (101 a, 101b, 101c) entsprechen, welche die Veränderung der Spannung (U_{cell}) gemäß der in der Zelle enthaltenen Ladung für unterschiedliche Gesundheitszustände der Zelle darstellen.

4. Verfahren nach einem der Ansprüche 1 bis 3, wobei der spezifische Wert der Ladung (Q_{A}) in dem Bereich von 20 % bis 60 % der vollen Nenn-Ladungskapazität der Zelle ist.

5. Verfahren nach einem der Ansprüche 1 bis 4, wobei die Zelle eine Lithium-Ionenzelle ist, und wobei der spezifische Wert der Ladung (Q_{A}) im Bereich von 38 % bis 42 % der vollen Nenn-Ladungskapazität der Zelle ist.

6. Verfahren nach Anspruch 5, wobei die Zelle eine Nennkapazität von 2,2 Ah hat und eine volle Nennladespannung von 4,2 V hat, und wobei der spezifische Wert der Spannung (U_{A}) im Bereich von 3,5 bis 3,6 V ist.

7. Verfahren nach einem der Ansprüche 1 bis 6, welches weiter eine vorherige Charakterisierungsphase aufweist, welche aufweist, für eine zweite Elementarzelle der gleichen Bauart wie die erste Zelle zumindest zwei Charakeristikkurven (101 a, 101b, 101c) aufzunehmen, welche die Veränderung der Spannung (U_{cell}) an der zweiten Zelle entsprechend der in der zweiten Zelle enthaltenen Ladung für mindestens zwei unterschiedliche Gesundheitszustände der zweiten Zelle darstellen.

8. Verfahren nach Anspruch 7, wobei die vorherige Charakterisierungsphase weiter einen Schritt aufweist, einen Kreuzungspunkt (A) der mindestens zwei Charakteristikkurven in dem Ladebereich von 20 % bis 60 % der Nennkapazität der Zelle zu bestimmen.

9. Verfahren zum Bewerten des Ladezustandes einer Elementarzelle einer Batterie, welches zumindest eine Phase einer Abschätzung des Ladezustandes der Zelle durch einen Ladezustandsabschätzungsalgorithmus aufweist, und mindestens eine Phase einer Nacheinstellung des Abschätzungsalgorithmus, wobei die Nacheinstellungsphase folgende Schritte aufweist:
Detektieren eines vordefinierten spezifischen Wertes der Ladung (Q_{A}), die in der Zelle enthalten ist, durch das Verfahren nach einem der Ansprüche 1 bis 8; und
Nachstellen des Ladungszustandsabschätzungsalgorithmus, indem die Differenz zwischen dem spezifischen Wert der Ladung (Q_{A}) und einem Ladungswert berücksichtigt wird, der durch den Abschätzungsalgorithmus zu einem Zeitpunkt der Detektion des spezifischen Ladungswertes abgeschätzt wurde.

10. System, welches Folgendes aufweist:
eine Batterie, die eine Vielzahl von Elementarzellen aufweist; und
eine Vorrichtung zum Managen der Batterie,
**dadurch gekennzeichnet, dass** die Managementvorrichtung ausgebildet ist, um mittels des Verfahrens nach einem der Ansprüche 1 bis 9 zu detektieren, dass eine Elementarzelle einen vorbestimmten spezifischen Wert der Ladung (Q_{A}) überschreitet.

11. System nach Anspruch 10, wobei die Batterie eine Batterie mit einer dynamisch rekonfigurierbaren Architektur ist und wobei die Managementvorrichtung dynamisch Zellen der Batterie abtrennen und wieder anschließen kann, so dass eine Wechselstromspannung an der Batterie geliefert wird.

12. System nach den Ansprüchen 11 und 2, wobei der Referenzstrom (I_{ref}) Null ist, und wobei die Schritte des Messens der Spannung (U_{cell}) an der ersten Zelle während Perioden ausgeführt werden, während denen die erste Zelle durch die Managementvorrichtung abgetrennt wurde, um eine Wechselstromspannung an der Batterie zu erzeugen.

## Claims

1. A method of detecting a predetermined specific value (Q_{A}) of the charge contained in a first elementary cell of a battery, comprising the steps of:
measuring the voltage (U_{cell}) across the cell at a plurality of times in a phase of cell charge or discharge between first and second state-of-charge levels; and
detecting a predetermined specific value (U_{A}) of this voltage, corresponding to the specific charge value (Q_{A}), **characterized in that** said specific charge (Q_{A}) and voltage (U_{A}) values correspond to the coordinates of a crossing point (A) of at least two curves (101a, 101b, 101c) representative of variation of said voltage (U_{cell}) according to the charge contained in the cell, for different states of health of the cell.

2. The method of claim 1, wherein said voltage (U_{cell}) is the voltage across the cell under a reference current (i_{ref}).

3. The method of claim 1 or 2, wherein said specific charge (Q_{A}) and voltage (U_{A}) values correspond to the coordinates of a crossing point (A) of at least three curves (101a, 101b, 101c) representative of the variation of said voltage (U_{cell}) according to the charge contained in the cell, for different cell states of health.

4. The method of any of claims 1 to 3, wherein said specific charge value (Q_{A}) is in the range from 20% to 60% of the nominal full charge capacity of the cell.

5. The method of any of claims 1 to 4, wherein said cell is a lithium-ion type cell and wherein said specific charge value (Q_{A}) is in the range from 38% to 42% of the nominal full charge capacity of the cell.

6. The method of claim 5, wherein said cell has a 2.2-Ah nominal capacity and a 4.2-V nominal full charge voltage, and wherein said specific voltage value (U_{A}) is in the range from 3.5 to 3.6 V.

7. The method of any of claims 1 to 6, further comprising a previous characterization phase comprising acquiring, for a second elementary cell of the same type as the first cell, at least two characteristic curves (101a, 101b, 101c) representative of the variation of the voltage (U_{Cell}) across the second cell according to the charge contained in the second cell, for at least two different states of health of the second cell.

8. The method of claim 7, wherein the previous characterization phase further comprises a step of determining a crossing point (A) of said at least two characteristic curves in the charge range from 20% to 60% of the nominal capacity of the cell.

9. A method of assessing the state of charge of an elementary cell of a battery, comprising at least one phase of estimation of the state of charge of the cell by a state-of-charge estimation algorithm, and at least one phase of readjustment of the estimation algorithm, said readjustment phase comprising the steps of:
detecting a predefined specific value (Q_{A}) of the charge contained in the cell by the method of any of claims 1 to 8; and
readjusting the state-of-charge estimation algorithm by taking into account the difference between said specific charge value (Q_{A}) and a charge value estimated by the estimation algorithm at a time of detection of said specific charge value.

10. A system comprising:
a battery comprising a plurality of elementary cells; and
a device for managing the battery,
**characterized in that** the management device is capable of detecting the crossing by an elementary cell of a predetermined specific charge value (Q_{A}) by the method of any of claims 1 to 9.

11. The system of claim 10, wherein the battery is a battery with a dynamically reconfigurable architecture, and wherein the management device is capable of dynamically disconnecting and connecting back cells of the battery so that an AC voltage is provided across the battery.

12. The system of claims 11 and 2, wherein said reference current (i_{ref}) is zero and wherein said steps of measurement of the voltage (U_{cell}) across the first cell are implemented during periods of disconnection of the first cell by the management device for the generation of an AC voltage across the battery.
